(19) Europäisches Patentamt

European Patent Office

Office européen des brevets

(11) **EP 0 764 852 A2**

(12) **EUROPÄISCHE PATENTANMELDUNG**

(43) Veröffentlichungstag:
26.03.1997 Patentblatt 1997/13

(51) Int. Cl.⁶: **G01R 31/26**

(21) Anmeldenummer: 96110716.6

(22) Anmeldetag: **02.07.1996**

(84) Benannte Vertragsstaaten:
**DE FR GB IT**

(30) Priorität: **27.07.1995 DE 19527538**

(71) Anmelder: **SIEMENS AKTIENGESELLSCHAFT**
**80333 München (DE)**

(72) Erfinder:
• **Franke, Torsten**
**01279 Dresden (DE)**
• **Türkes, Peter, Dr.**
**82008 Unterhaching (DE)**

(54) **Verfahren zur getrennten Erfassung von Ladungsanteilen in Halbleiterbauelementen und Anordnung zu dessen Durchführung**

(57)      Der Anmeldungsgegenstand betrifft ein Verfahren, bei dem bei Halbleiterbauelementen mit bipolarem Anteil, insbesondere bei IBGTs, die während der Speicherzeit veränderte Summenladung im Emitter des zu untersuchenden Bauelements (DUT) in eine durch einen Vorwärtsstrom injizierte Ladung, eine nachinjizierte Ladung und eine durch Rekombination abgebaute Ladung zerlegbar ist und dadurch das Schaltverhalten auch außerhalb eines eingeschränkten Betriebsbereiches bestimmt werden kann.

FIG 1

**Beschreibung**

Wie hinreichend bekannt, werden Leistungshalbleiter zunehmend in Anwendungen mit hohen Frequenzen eingesetzt. Dabei ist für einen optimalen Schaltungsentwurf die Kenntnis des transienten Verhaltens des Halbleiters von großer Bedeutung. Im besonderen bestimmt die transiente Ladungsträgerverteilung in Halbleiterbauelementen mit bipolaren Anteilen, zum Beispiel in bipolaren Transistoren mit isoliertem Gate (IGBT), alle elektrotechnisch relevanten Eigenschaften dieser Bauelemente. Voraussage des Bauelementenverhaltens in neuen Applikationen gründet sich derzeit auf Datenblattangaben hinsichtlich der im Bauelement enthaltenen Summenladung, wobei diese jedoch nur in einem eingeschränkten Betriebsbereich des Bauelements gelten.

Die in einem Halbleiter gespeicherte Ladung läßt sich mittels Kommutierungsschaltungen verschiedenster Ausformung erfassen, wobei allen diesen Schaltungen gemeinsam ist, daß sie äquivalent zu Applikationen in der Leistungselektronik arbeiten und deshalb die elektrischen Parameter, welche die transiente Ladungsträgerverteilung bestimmen, wie Vorwärtsstrom $I_f$, Rückwärtsstrom $I_r$ und Kommutierungssteilheit $dI/dt$, zumindest teilweise durch die Kommutierungszweige miteinander verknüpft sind und somit nicht unabhängig voneinander festgelegt werden können. Dadurch ist die im zu testenden Bauelement enthaltene Summenladung nicht in ihre Bestandteile zerlegbar.

Aus dem Buch von Rudolf Lappe, „Leistungselektronik-Meßtechnik",Carl Hanser Verlag, München u. Wien, 1983, insbesondere Seiten 84 bis 91, sind grundlegende Angaben zu Messungen an Thristoren und Dioden bekannt.

Die der Erfindung zugrundeliegende Aufgabe besteht nun darin, ein Verfahren und eine Anordnung zu dessen Durchführung anzugeben, bei dem oder mit Hilfe derer Ladungsanteile in einer Halbleiterschichtanordnung eines Bauelements nach ihrer Entstehung und Wirkung getrennt ermittelt werden. Die Aufgabe wird hinsichtlich des Verfahrens durch die Merkmale des Patentanspruchs 1 und hinsichtlich der Anordnung durch die Merkmale des Patentanspruchs 3 gelöst.

Der Patentanspruch 2 betrifft eine vorteilhafte Ausgestaltung des erfindungsgemäßen Verfahrens und die Patentansprüche 4 bis 7 betreffen vorteilhafte Weiterbildungen der Anordnung gemäß Patentanspruch 3.

Die Erfindung wird nachfolgend anhand der Zeichnungen näher erläutert. Dabei zeigt

Figur 1      eine Schaltungsanordnung zur Durchführung des erfindungsgemäßen Verfahrens,

Figur 2      ein Zeitdiagramm der in der Schaltung von Figur 1 auftretenden Ströme in Abhängigkeit von Schalterzusständen,

Figur 3      ein Oszillogramm des zeitlichen Verlaufes von Strom und Spannung an der zu testenden Halbleiterschichtanordnung und in

Figur 4      ein Diagramm der Summenladung in Abhängigkeit des Rückwärtsstromes.

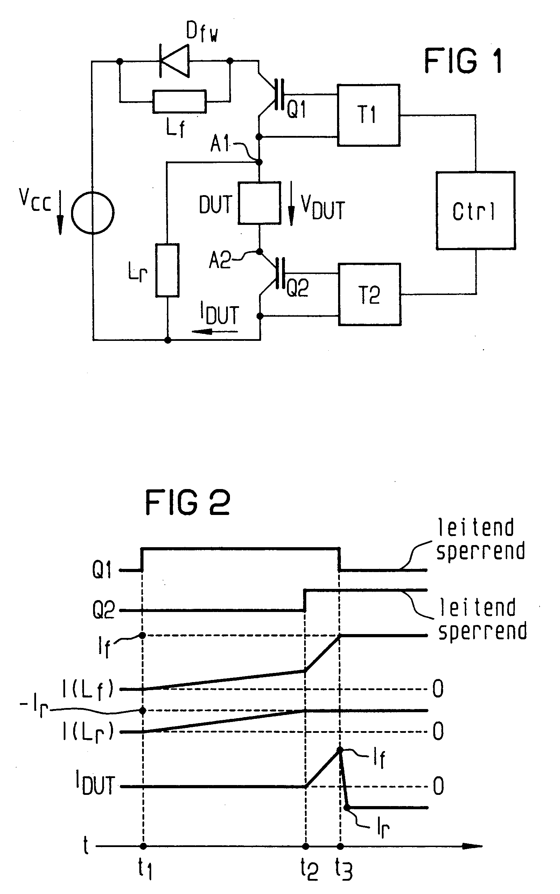

In Figur 1 ist eine Schaltung zur Durchführung des erfindungsgemäßen Verfahrens gezeigt, bei der ein Anschluß A1 einer zu testenden Halbleiterschichtanordnung DUT (device under test) über eine aus einem Schalter Q1 und einer Induktivität $L_f$ bestehenden Reihenschaltung mit einem ersten Anschluß einer Gleichspannungsquelle $V_{CC}$ und ein Anschluß A2 der Halbleiterschichtanordnung DUT über einen Schalter Q2 mit einem zweiten Anschluß der Gleichspannungsquelle $V_{CC}$ verbunden ist. Darüber hinaus ist der Anschluß A1 über eine Induktivität $L_r$ mit dem zweiten Anschluß der Gleichspannungsquelle $V_{CC}$ verbunden. Die Induktivität $L_f$ ist durch eine Freilaufdiode $D_{fw}$ überbrückt, die bezüglich der Gleichspannungsquelle $V_{CC}$ in Sperrichtung geschaltet ist.

Die Schalter Q1 und Q2 sind in Figur 1 als MOS-Feldeffekttransistoren dargestellt, können jedoch im Grunde durch beliebige Schalter realisiert werden.

Die zu testende Halbleiterschichtanordnung DUT wird von einem Strom $I_{DUT}$ durchflossen und zwischen den Anschlüssen A1 und A2 liegt eine Spannung $V_{DUT}$ an.

Die Halbleiterschichtanordnung DUT und der Schalter Q2 können dabei sowohl innerhalb eines Halbleiterbauelementes oder auch in Form von getrennten Bauelementen auftreten. Auf diese Weise kann beispielsweise bei einem IGBT die darin enthaltene MOSFET-Struktur als Schalter Q2 ausgenützt werden und die zu testende Halbleiterschichtanordnung besteht hierbei nur aus dem für die Ermittlung der Summenladungskomponenten relevanten pn-Übergang, also einer im IGBT enthaltenen Diode.

Bevorzugt werden für die Schalter Q1 und Q2 avalanchefeste MOS-Feldeffekttransistoren verwendet.

Der Schalter Q1 wird beispielsweise durch einen Treiber T1 und der Schalter Q2 durch einen Treiber T2 angesteuert, die ihrerseits durch eine Steuereinheit Ctrl angesteuert werden.

Der Schalter Q1 kann vorteilhafterweise mit einem Überspannungsschutz versehen werden, wodurch die Schalter Q1 und Q2 sowie die Halbleiterschichtanordnung DUT vor einem Durchbruch geschützt werden.

Durch die beiden Induktivitäten $L_f$ und $L_r$ wirken hier in dieser Beschaltung im Grunde wie Konstantstromquellen, die jedoch elektronisch nur wesentlich aufwendiger realisierbar sind.

In Figur 2 sind der durch die Induktivität $L_f$ fließende Strom $I(L_f)$, der durch die Induktivität $L_r$ fließende Strom $I(L_r)$ sowie der durch die Halbleiterschichtstruktur fließende Strom $I_{DUT}$ für ihren zeitlichen Ablauf und in Abhängigkeit der Schalterzustände der Schalter Q1 und Q2 dargestellt.

Sobald der Schalter Q1 im Zeitpunkt $t_1$ leitend wird

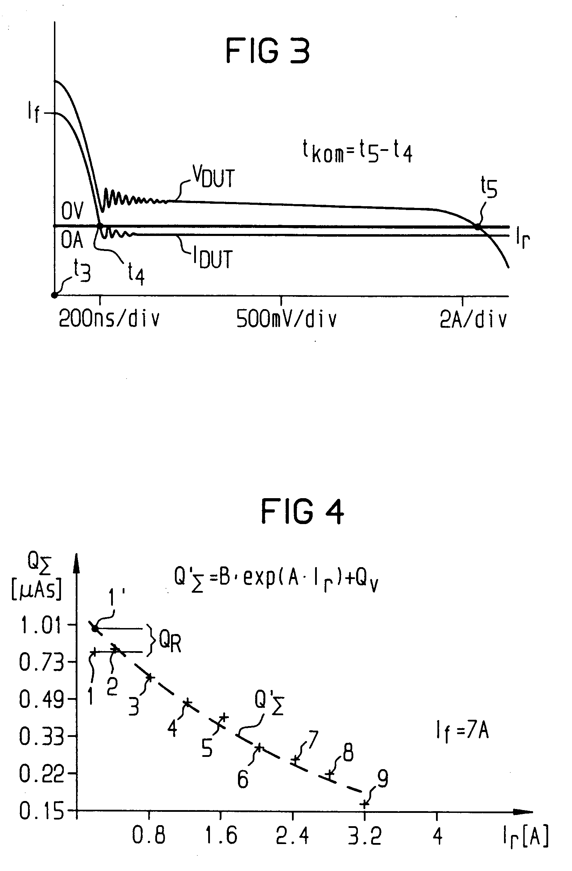

steigt der Strom $I(L_f)$ und der Strom $I(L_r)$ proportional zu $V_{CC}*t/(L_f + L_r)$ bis zu einem Zeitpunkt $t_2$ bei dem auch der Schalter Q2 leitend wird. Der Strom $I_{DUT}$ ist zwischen den Zeitpunkt $t_1$ und $t_2$ gleich Null. Zum Zeitpunkt $t_2$ erreicht der Strom $I(L_r)$ den Wert $-I_r$. Nach dem Zeitpunkt $t_2$ steigt der Strom $I(L_f)$ proportional zu $V_{CC}*t/(L_f)$ und der Strom $I(L_r)$ bleibt konstant auf dem Wert $-I_r$. Dies geschieht solange bis der Schalter Q1 zu einem Zeitpunkt $t_3$ sperrt und damit der Strom $I(L_f)$ mit einem konstanten Wert $I_f+I_r$ weiterfließt und der Strom $I_{DUT}$ den Wert $I_f$ annimmt. Kurz nach dem Zeitpunkt $t_3$ fällt der Strom $I_{DUT}$ relativ stark auf den danach weitgehend konstanten Rückstromwert $-I_r$ ab, was in Figur 3 unter anderem genauer gezeigt ist. Wie stark der Strom $I_{DUT}$ abfällt, kann dabei durch den Schalter Q1 eingestellt werden, wobei ein zu steiler Abfall zu einem vermehrten Einschwingen führt und ein zu flacher Abfall keine hinreichend genaue, Bestimmung der Ladungsaufteilung durch Einstellung des Stromes $I_f$ mehr ermöglicht.

In Figur 3 ist der Abfall des Stromes $I_{DUT}$ und der Spannung $V_{DUT}$ nach dem Zeitpunkt $t_3$ dargestellt. Zum Zeitpunkt $t_4$ hat der Strom $I_{DUT}$ beim Übergang vom Vorwärtsstrom $I_f$ auf den negativen Rückwärtsstrom $I_r$ seinen Nulldurchgang und zum Zeitpunkt $t_5$ hat die Spannung $V_{DUT}$ ihren Nulldurchgang bzw. ihren Steilabfall. Die Zeit zwischen den Zeitpunkten t4 und t5 wird als Kommutierungszeit $t_{kom}$ bezeichnet. Da der Rückwärtsstrom $I_r$ zwischen den Zeitpunkten $t_4$ und $t_5$ weitgehend konstant ist, kann eine Summenladung $Q_\Sigma$ durch Produktbildung aus dem Rückwärtsstrom $I_r$ und der Kommutierungszeit $t_{kom}$ berechnet werden. Der Rückwärtsstrom $I_r$ durch die Halbleiterschichtanordnung DUT ist mittels der Zeitspanne $t_2-t_1$ und der Vorwärtsstrom $I_f$ durch die Zeitspanne $t_3-t_2$ einstellbar.

Die Induktivität $L_r$ ist vorteilhafterweise größer als die Induktivität $L_f$ dimensioniert, da hierdurch in der Zeitspanne $t_3-t_2$ der Strom $I(L_r)$ weitgehend konstant ist.

Es werden nun mehrere Werte 1 ... 9 der Summenladung $Q_\Sigma$ bei konstantem Vorwärtsstrom $I_f$ und einem jeweiligen Rückwärtsstrom $I_r$ sowie auch einer jeweiligen Kommutierungszeit $t_{Kom}$ ermittelt, was in Figur 4 dargestellt ist. Daraufhin wird aus Summenladungswerten für mittlere Rückstromwerte 2 ... 8 eine Näherungsfunktion $Q'_\Sigma = Q_N+Q_V=B*exp(A*I_r)+Q_V$, beispielsweise durch Minimierung der Abweichungsquadrate, ermittelt, wobei $Q_N$ eine nachinjizierte Ladung und $Q_V$ eine vom Vorwärtsstrom injizierte Ladung bedeuten. Niedrige Rückstromwerte, wie zum Beispiel im Punkt 1, können gegenüber mittleren Rückstromwerten in den Punkten 2..8 dadurch abgegrenzt werden, daß beispielsweise das jeweilige Abweichungsquadrat für niedrige Rückstromwerte wesentlich größer ist als ein nur durch die Meßungenauigkeit bedingtes Abweichungsquadrat. Hohe Rückstromwerte, wie zum Beispiel im Punkt 9, können eventuell zusätzlich gegenüber mittleren Rückstromwerten 2..8 abgegrenzt werden, da beispielsweise hier die Meßgenauigkeit zu gering ist und die Näherungsfunktion hierdurch unnötig verfälscht würde.

Danach wird eine durch Rekombination abgebaute Ladung $Q_R$ dadurch bestimmt, daß für einen niedrigen Wert des Rückwärtsstromes $I_r$ eine Differenz zwischen der aus dem Rückstrom und der Kommutierungszeit ermittelten Summenladung $Q_\Sigma$ im Punkt 1 und der gemäß der Näherungsformel bestimmten Summenladung $Q'_\Sigma(1')$ im Punkt 1' gebildet wird. Die Näherungsfunktion $Q'_\Sigma$ wird hierbei über den Punkt 2 hinaus bis zum Punkt 1' extrapoliert, wobei der Punkt 1 und der Punkt 1' bei gleichem Rückstrom $I_r$ ermittelt werden.

Aus $Q_\Sigma(1)$ im Punkt 1, $Q'_\Sigma(1')$ im Punkt 1' und $t_{Kom}(1')$ im Punkt 1' kann die durchschnittliche Ladungsträgerlebensdauer $\tau$ durch die Formel

$$\tau = t_{Kom}(1') / \ln( Q'_\Sigma(1')/Q_\Sigma(1) )$$

ermittelt werden. Die durch Rekombination abgebaute Ladung $Q_R(P')$ kann mit Hilfe des Zusammenhangs

$$Q_R(P')= Q'_\Sigma(P')*(1-exp(t_{Kom}(P')/\tau))$$

auch für weitere Punkte, zum Beispiel für die Punkte P'= 2...9 angegeben werden, wobei $t_{Kom}(P')=Q'_\Sigma(P')/I_R(P')$ mit $I_R(P')=I_R(P)$ gilt.

Eine jeweilige nachinjizierte Ladung $Q_N(P)$ wird daraufhin so bestimmt, daß die aus dem jeweiligen Rückwärtsstrom und der jeweiligen Kommutierungszeit ermittelte Summenladung $Q_\Sigma(P)$ um die vom Vorwärtsstrom injizierte Ladung $Q_V$ vermindert und um die jeweilige durch, die Rekombination abgebaute Ladung $Q_R(P)$ vermehrt wird. Es gilt $Q_N(P)= Q_\Sigma(P)-Q_V+Q_R(P)$ mit $Q_R(P)\cong Q_R(P')$. Fur hohe Rückwärtsstromwerte Ir, wie zum Beispiel im Punkt 9, ist wegen der Unsicherheit von $Q_\Sigma(P)$ der Zusammenhang $Q_N(P)\cong Q_N(P')= Q_\Sigma(P)-Q_V$ für die Bestimmung von $Q_N(P)$ besser geeignet.

## Patentansprüche

1. Verfahren zur getrennten Erfassung von Ladungsanteilen $Q_V$, $Q_N(1)$, $Q_R(1)$ einer Summenladung $Q_\Sigma(1)$ einer Halbleiterschichtanordnung (DUT),

- bei dem ein Vorwärtsstrom ($I_f$) und eine Mehrzahl von Rückstromwerten ($I_r(P)$, P= 1 ... 9) eingestellt werden,
- bei dem für die Mehrzahl von Rückwärtsstromwerten eine jeweilige Summenladung ($Q_\Sigma(P)$, P=1 ... 9) dadurch ermittelt wird, daß ein jeweiliger Rückwärtsstromwert ($I_r(P)$) mit einer jeweiligen Kommutierungszeit ($t_{Kom}(P)$) multipliziert wird, wobei die jeweilige Kommutierungszeit die Zeit zwischen einem Zeitpunkt ($t_4$) des Nulldurchgangs des Meßstromes ($I_{DUT}$) und einem Zeitpunkt ($t_5$) des Nulldurchgangs der Meßspannung ($V_{DUT}$) bedeutet,
- bei dem für mittlere Rückstromwerte ($I_r(P)$; P=2 ... 8) eine Näherungsfunktion ($Q'_\Sigma(P)$) vom

Typ $B^*\exp(A^*I_r) + Q_V$ ermittelt wird und hierbei die Parameter B, A und die durch den Vorwärtsstrom injizierte Ladung $Q_V$ bestimmt werden,

- bei dem eine durch Rekombination abgebaute Ladung $Q_R(1)$ dadurch bestimmt wird, daß für einen kleinen Rückwärtsstromwert $(I_r(1))$ eine Differenz zwischen einer aus dem Rückwärtsstromwert und der Kommutierungszeit ermittelten Summenladung $Q_\Sigma(1)$ und einer gemäß der Näherungsfunktion bestimmten Näherungsummenladung $Q'_\Sigma(1')$ gebildet wird, und
- bei dem eine nachinjizierte Ladung $(Q_N(1))$ dadurch bestimmt wird, daß die Summenladung um die vom Vorwärtsstrom injizierte Ladung $Q_V$ vermindert und um die durch Rekombination abgebaute Ladung $(Q_R(1))$ vermehrt wird.

2. Verfahren nach Anspruch 1,

- bei dem aus der Summenladung $Q_\Sigma(1)$, der Näherungssummenladung $Q'_\Sigma(1')$ und einer aus dem Quotient aus der Näherungssummenladung $Q'_\Sigma(1')$ und einem zugehörigen Rückwärtsstrom $(I_r(1))$ bestimmten Kommutierungszeit $t_{Kom}(1')$ die durchschnittliche Ladungsträgerlebensdauer $\tau$ durch die Formel

$$\tau = t_{Kom}(1')/\ln(Q'_\Sigma(1')/Q_\Sigma(1))$$

ermittelt werden,
- bei dem eine durch Rekombination abgebaute Ladung $Q_R(P')$ mit Hilfe des Zusammenhangs

$$Q_R(P') = Q'_\Sigma(P')^*(1-\exp(t_{Kom}(P')/\tau)$$

auch für für mindestens eine weitere Kommutierungszeit $t_{Kom}(P')$ ermittelt wird, wobei $t_{Kom}(P')$ mit Hilfe eines Quotienten aus einer jeweiligen Näherungsummenladung $Q'_\Sigma(P'))$ und einem jeweiligen Rückwärtsstrom $(I_r(P))$ bestimmt wird und
- bei dem mindestens eine weitere nachinjizierte Ladung $Q_N(P)$ dadurch bestimmt wird, daß eine jeweilige Summenladung $Q_\Sigma(P)$ um die vom Vorwärtsstrom injizierte Ladung $Q_V$ vermindert und um die jeweilige durch die Rekombination abgebaute Ladung $Q_R(P')$ vermehrt wird.

3. Anordnung zur Durchführung des Verfahrens nach Anspruch 1 oder 2,

- bei der ein erster Anschluß einer Gleichspannungsquelle $(V_{CC})$ über eine erste Induktivität $(L_f)$ und einen ersten Schalter (Q1) mit einem ersten Anschluß (A1) der Halbleiterschichtanordnung (DUT) verbindbar ist, wobei letzterer über eine zweite Induktivität $(L_r)$ mit einem zweiten Anschluß der Gleichspannungsquelle geschaltet ist,
- bei der ein zweiter Anschluß (A2) der Halbleiterschichtanordnung (DUT) über einem zweiten Schalter (Q2) mit dem zweiten Anschluß der Gleichspannungsquelle verbindbar ist,
- bei der eine Steuereinheit (Ctrl) vorgesehen ist, die dem ersten Schalter (Q1) zu einem ersten Zeitpunkt $(t_1)$ und den zweiten Schalter zu einem zweiten Zeitpunkt $(t_2)$ durchschaltet sowie den ersten Schalter zu einem dritten Zeitpunkt $(t_3)$ wieder öffnet,
- bei der der Rückwärtsstrom $(I_r)$ durch die Zeitdauer zwischen dem ersten Zeitpunkt $(t_1)$ und dem zweiten Zeitpunkt $(t_2)$ einstellbar ist und
- bei der der Vorwärtsstrom $(I_f)$ durch die Zeitdauer zwischen dem ersten Zeitpunkt und dem dritten Zeitpunkt $(t_3)$ einstellbar ist.

4. Anordnung nach Anspruch 3,
bei der der zweite Schalter (Q2) und die Halbleiterschichtanordnung (DUT) in ein gemeinsames Halbleiterbauelement integriert sind.

5. Anordnung nach Anspruch 4,
bei der das Halbleiterbauelement aus einem Bipolartransistor mit isoliertem Gate (IGBT) besteht, wobei die Halbleiterschichtanordnung (DUT) aus einem pn-Übergang und der zweite Schalter (Q2) aus einem MOS-Feldeffekttransistor besteht.

6. Anordnung nach einem der Ansprüche 3 bis 6,
bei der der Induktionswert der zweiten Induktivität $(L_r)$ wesentlich größer ist als der Induktionswert der ersten Induktivität $(L_f)$.

7. Anordnung nach einem der vorhergehenden Ansprüche,
bei der der erste Schalter (Q1) mit einem Überspannungschutz versehen ist.

FIG 1

FIG 2

# FIG 3

$t_{kom} = t_5 - t_4$

$I_f$

$V_{DUT}$

0V

0A

$I_{DUT}$

$t_5$

$I_r$

$t_3$  $t_4$

200ns/div          500mV/div          2A/div

# FIG 4

$Q_\Sigma$
$[\mu As]$

$Q'_\Sigma = B \cdot exp(A \cdot I_r) + Q_v$

1'

1.01

0.73     $\}Q_R$

1  2

0.49     3

4

$Q'_\Sigma$     $I_f = 7A$

0.33              5     7     8

6

0.22                       9

0.15

0.8     1.6     2.4     3.2     4     $I_r[A]$